# EUROPEAN PATENT APPLICATION

(11) **EP 3 809 459 A1**
(43) Date of publication of application: **21.04.2021**
(21) Application number: 19823678.8
(22) Date of filing: 04.03.2019
(51) Int. Cl.: H01L 25/04, H05K 1/18, H05K 7/20

(54) **METHOD OF MANUFACTURING A THREE-DIMENSIONAL ELECTRONIC MODULE HAVING HIGH COMPONENT DENSITY, AND DEVICE**

(30) Priority: 18.06.2018 RU 2018122096
(71) Applicant: Sokolov, Yuriy Borisovich, Moskovskaya obl. 141195 (RU)
(72) Inventor: Sokolov, Yuriy Borisovich, Moskovskaya obl. 141195 (RU)
(74) Representative: Spengler, Robert
(86) International application number: PCT/RU2019/000141
(87) International publication number: WO 2019/245402

(57) **Abstract**

The invention relates to the field of techniques for manufacturing electronic devices having surface-mounted components, and can be used in avionics, telecommunication, lighting technology, and other fields, and can be configured as a power source, a converter, sensors,etc. The technical result consists in improved weight and dimension characteristics, improved heat dispersion, and increased electromagnetic screening. The present electronic module comprises a printed circuit board in the form of a three-dimensional structure, faces of which are formed by flat sections of the printed circuit board, and edges of which are formed by fold lines between the sections of the printed circuit board, wherein the mounting surface of the printed circuit board faces the inside of the three-dimensional structure, and electronic components and assemblies are grouped on the mounting surface of at least two sections of the printed circuit board such that the electronic components and assemblies of one section are disposed in the empty space between the components and assemblies of another section of the printed circuit board.

## Description

### Pertinent Art

The present invention relates to the technical area of manufacturing of electronic devises fitted with surface-mount components and can be applied in avionics, telecommunications, lighting engineering and other fields, and can be configured as a power source, converter, sensor etc.

### Prior Art

The method of assembly of a light-emitting three-dimensional electronics package is known as that comprising electronic components installed on a planar metal board, a planar board installed on a heat sink which surface has a hemispherical shape, a planar board folded into a three-dimensional spherical unit with the latter fixed on the heat sink surface (CN 102595788, H01L33/64, published on 18.07.2012).

The known technique of manufacturing of an open light-emitting unit that cannot be suitable for creating a protected universal three-dimensional electronic unit to have components placed in the unit chamber is described herein.

There is a solution according to which surface-mount components are installed on eight-layer board sections with a four-layer flexible section of the board folded so that surface-mount components occur between eight-layer sections of the board, thus forming a three-dimensional U-shaped structure of the stiff-plastic printed-circuit board (CN103730446, H01L21/56, published on 16.04.2014).

This solution suffers from the drawback of limited applicability of SMT elements, failure to use any through-hole elements, and unavailability of a rigid base.

The known technique is disclosed in application US 2005270750 according to which the protected three-dimensional electronic unit comprises a stack of printed-circuit boards on each of which a group of single-type electronic components is preliminary installed. Each of the printed-circuit boards is fixed to its rigid frame made of heat-conductive material and commonly they produce a real a heat sink. Components on every board are installed in the chamber between adjacent boards (US2005270750, H05K 7/20, published on 8.12.2005).

The disadvantage of the above prior art is that it is difficult to extract heat out of closed cavities of the three-dimensional unit, there are no means to select configuration of the unit and it is not possible to use through-hole elements.

The technical result of the claimed solution is improved weight-and-size characteristics of a finished item owing to more compact arrangement of components; better dissipation of heat from components; and more intensive electromagnetic shielding behavior.

The prior art in patent CN 102595788 has been selected as the closest one that agrees with the claimed solution by a majority of features.

The invention is characterized by the following set of features:
The method of manufacturing of a three-dimensional electronics package of compactly accommodated components including:
producing a metal-base printed-circuit board workpiece;
installation of electronic components on the surface of the printed-circuit board;
folding of the printed-circuit board;
characterized in that:
   a workpiece of the printed-circuit board is used as an fold-up unit, the flat surface areas of which form a n-angle, where n ≥ 2, and applicable for producing foldable sections;
   fold-up surface areas are marked out with bend lines;
   electronic components are installed by means of grouping electronic components on the mounting surface of at least two sections of the fold-up printed-circuit board;
   the fold-up printed-circuit board is bent so that the parts of the workpiece consecutively turned around the bend line till electronic components of one section are brought into a free space between electronic components of another or of several other sections of the board.

The expression "mark out with bend lines" means a technological pattern of lines laid out between sections of the board along which bending will be made with the board placed in a special fixture. In particular, such technological pattern can be designed so that to provide a number of through or blind holes that designate end points of the line in order to relieve plastic deformation of the fold-up board.

Sections of the fold-up board create faces a spatial structure and can form a polyhedron including a cube, parallelepiped, prism structure, truncated pyramid, or another spatial closed or non-closed cavity structure. A spatial structure of the printed-circuit board can have N-faces, where N is a natural number as taken from the expression: N ≥ 3. A spatial structure and its fold-up shape are specified in the engineering stage against problems to be solved.

Layout of components on the board sections is selected throughout the engineering stage with due reference to the desired shape of the unit and taking into account specific schematic and heating engineering features, as well as technological unit shaping features.

Surface-mount components, output components and electronic units are installed on the fold-up printed-circuit board, therein they are grouped on the surface of at least two sections of the printed-circuit board in such a way that during consecutive bending of the board the spatial area of components and electronic units will be kept unchanged while dimensions of the spatial area between components and units will change. As a result, electronic components of one section of the printed-circuit board will be placed so that to fill free space between electronic components and units of another or several other sections of the board.

Expression "spatial area of a component" in the application means volume of space covered by a board-mount component depending on its geometric dimensions.

For expanding functionality, at least one fold-up section can be fitted with a connector for installation of at least one through-hole component or electronic unit on the additional board.

With the aluminum-base metal printed-circuit board used, heat can be efficiently taken off any power components.

A fabricated electronics package, where necessary, can be encased in the flexible electrical insulation with natural or polymeric filler.

For improving heat-exchange characteristics, the package can be placed in an additional box and encased in curable heat-conducting compound.

Various phases of the manufacturing process are shown in the following drawings for illustrative purpose wherein a secondary power supply three-dimensional unit is demonstrated as that having a spatial parallelepiped-shaped structure.

Fig. 1 - a fold-up printed-circuit board with fold-up component-mount sections and with marked bend lines.

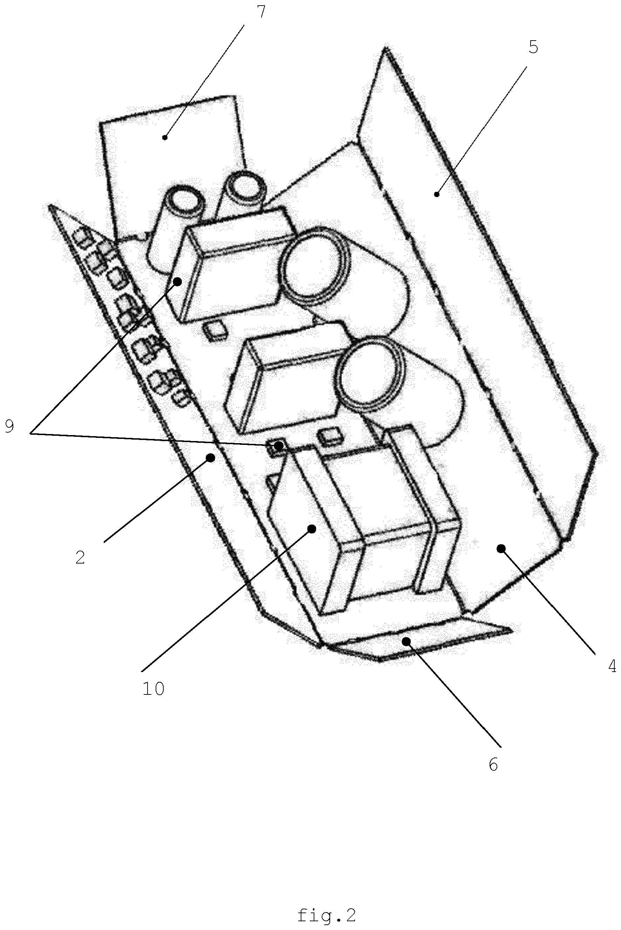

Fig. 2 - a 3D image of an intermediate stage during which a spatial structure of the three-dimensional electronic unit is fabricated which fold-up is shown in Fig. 1.

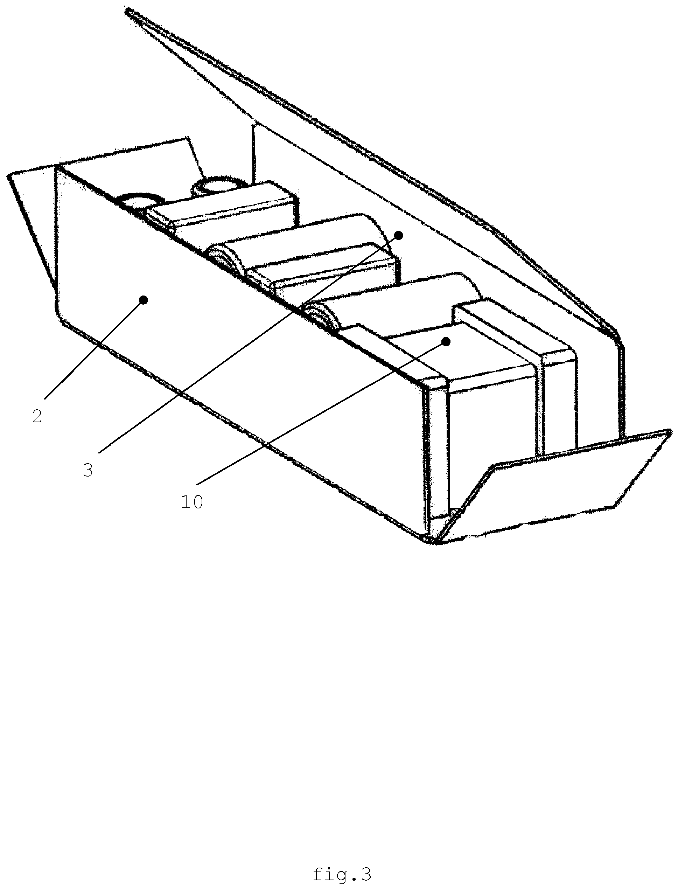

Fig. 3 - a 3D image of a final stage during which a spatial structure of the three-dimensional electronic unit is fabricated is shown in Fig. 2.

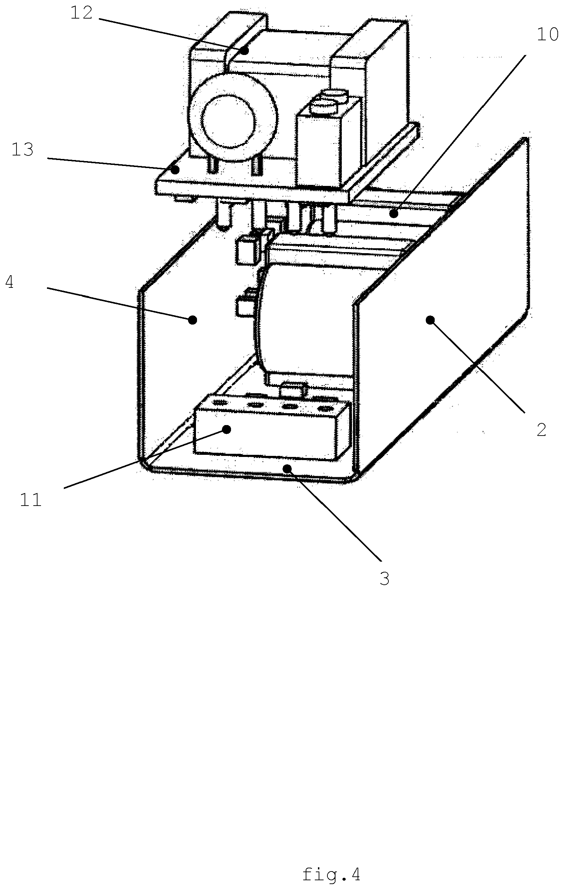

Fig. 4 - a 3D image of an option of the three-dimensional electronic unit optionally combined with surface-mount and through-hole components.

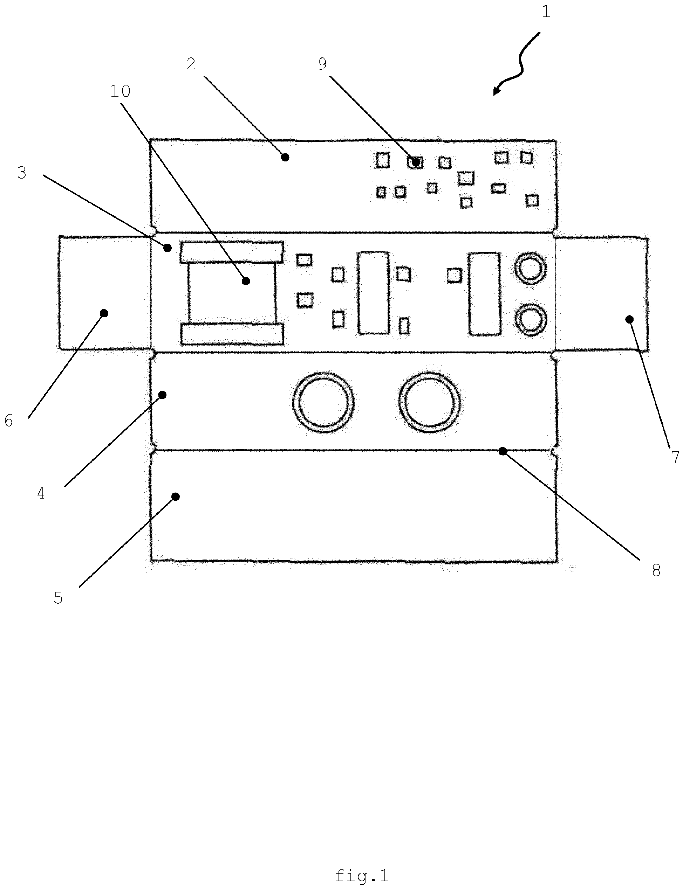

There are elements in the drawings having the items as follows:
1 - a fold-up hex workpiece of the printed-circuit board,
2,3,4,5,6,7 - fold-up board sections shown in Fig. 1,
8 - printed-circuit board bend lines,
9 - surface-mount components (SMT)
10 - through-hole components (TNT)
11 - through-hole component connector
12 - electronic functional unit,
13 - electronic functional unit board

### Exemplary Embodiment

Workpiece 1 of the printed-circuit board is made as a fold-up with six rectangular sections 2, 3, 4, 5, 6, 7 separated by lines 8 at the printed-circuit board bend. Surface-mount 9 and through-hole components 10 are grouped at sections 2, 3, and 4 of board 1. Other section surfaces of printed-circuit board 1 can be used for accommodating components.

On installing components, printed-circuit board 1 is bent along lines 8 between the sections of the board so that sections 2-7 take up the position of lateral and end hexagonal faces and electronic components 9, 10 mounted at sections 2 and 4 of the board are brought to the hexagonal cavities and placed in free space between the components of section 3 of the board. The fold-up sections 6, 7 close the hexagonal end faces and section 5 closes the hexagonal cavity. Such grouped structure makes it possible to significantly improve compact layout of components while metal base of the board can be effective in removing heat from the package.

It should be noted again that the spatial structure faces can be designed open. Open design, where necessary, is suitable for creating channels in order to provide convective cooling air to the electronics package fabricated by the above-mentioned technique.

The claimed solution can be implemented using universal mounting and bending fixtures.

## Claims

1. The method of manufacturing of a three-dimensional electronics package of compactly accommodated components including the stages as follows: making of a workpiece of the metal-based printed-circuit board; bending of the printed-circuit board, and installation of electronic components on its surface,
**characterized in that**
a workpiece of the metal printed-circuit board is used as an fold-up unit, the flat surface areas of which form a n-angle, where n ≥ 2, and suitable for forming the edges of the spatial structure;
surface-mount, through-hole components and electronic units are installed on the fold-up printed-circuit board, therein they are grouped on the surface of at least two sections of the printed-circuit board so that their spatial areas will be kept unchanged during consecutive bending of the board;
the fold-up printed-circuit board is bent so that the parts of the workpiece consecutively turned around the bend line till electronic components of one section are brought into a free space between electronic components of another or of several other sections of the board.

2. The method of manufacturing of the printed-circuit board of claim 1 **characterized in that** the bend line between the sections of the board is followed by through holes at ends of the bend line.

3. The three-dimensional electronics package of compactly accommodated components comprising a metal-base printed-circuit board; and electronic components installed on the mounting surface of the printed-circuit board,
**characterized in that**
the printed-circuit board is designed as a spatial structure which faces are produced by flat sections of the printed-circuit board, each of which has the shape of an n - gon, where n> 2, and ribs on the surface of the spatial structure - the fold line between the flat areas of the printed circuit board,
wherein the mounting surface of the printed-circuit board faces inwards the spatial structure;
electronic components are grouped on the mounting surface of at least two sections of the printed-circuit board so that electronic components and units of one section are located inside free space between the components and units of the printed-circuit section.

4. The three-dimensional electronics package of claim 3 **characterized in that** the spatial structure of the printed-circuit board has N-faces where N is a natural number as taken from the expression: N ≥ 3.

5. The three-dimensional electronics package of claim 3, **characterized in that** the spatial structure is shaped as a right-angle tetrahedral prism every face of which is a rectangular.

6. The three-dimensional electronics package of claim 3, **characterized in that** at least one section of the printed-circuit board is fitted with a connector for installing at least one through-hole (THT) component or electronic unit.
